# EUROPEAN PATENT APPLICATION

(11) **EP 1 691 428 A2**
(43) Date of publication of application: **16.08.2006**
(21) Application number: 06101039.3
(22) Date of filing: 30.01.2006
(51) Int. Cl.: H01L 51/00

(54) **High performance organic materials for solar cells**

(30) Priority: 09.02.2005 US 55394
(71) Applicant: Hewlett-Packard Development Company, L.P., Houston, TX 77070 (US)
(72) Inventor: Zhou, Zhang-Lin, Palo Alto, CA94304-1100 (US)
(74) Representative: Durville, Guillaume

(57) **Abstract**

The present invention is drawn to a composition or layered composite for absorbing and utilizing radiant energy in a solar cell. The composition can comprise a blend of a push-pull copolymer including at least one electron donor entity and at least one electron acceptor entity, and a fullerene composition. The layered composite can comprise a push-pull copolymer including at least one electron donor entity and at least one electron acceptor entity configured in a first layer, and a fullerene composition configured in a second layer. The first layer is typically in contact with the second layer.

## Description

### FIELD OF THE INVENTION

The present invention relates generally to high performance polymer solar cells. More particularly, the present invention is drawn to various blends or layered composites of electron acceptors and electron donors, which can include fullerene and fluorene derivatives.

### BACKGROUND OF THE INVENTION

Due to the limited supply of many energy sources, interest in the development renewable energy sources which neither run out nor have any significant harmful effects on the environment is expanding. One such renewable energy source comes from solar power. As is generally known, the conversion of solar light into electric power typically requires the generation of both negative and positive charges as well as a driving force that can push these charges through an external electric circuit. For example, solar cells comprising an inorganic semi-conductor such as mono- and multi-crystalline silicon have been developed. These conventional solar cells can harvest up to 24% of the incoming solar energy. However, the production of these solar cells typically requires implementing many energy intensive processes at high temperatures and high vacuum conditions, which leads to high manufacturing costs.

On the other hand, considerably less effort and energy is necessary if organic semi-conductors are used. This is because simpler processing at much lower temperatures are necessary than is typically required for the production of inorganic solar cells. Examples of organic semi-conductors that can be used include semi-conducting polymers, such as conjugated polymers. The development of conjugated polymer solar cells is in an early stage, and many issues related to materials and device development are still being resolved. Some of the limitations of the current devices include relatively low mobility of charge carriers and the narrow solar absorption bands.

In order to increase the efficiency of solar cells that utilize organic semi-conductors, the absorption of the active absorbing materials should cover a greater band width of the visible solar spectrum, e.g., the bandgap should be reduced.

### SUMMARY OF THE INVENTION

It has been recognized that high performance polymer solar cells can be prepared that have a greater band width absorption spectrum by preparing blends of materials that efficiently absorb most, if not all, of the solar visible spectrum. In accordance with this, a composition for use as an active absorbing material in a solar cell is provided. More specifically, a composition for absorbing and utilizing radiant energy in a solar cell can comprise a blend of a push-pull copolymer including at least one electron donor entity and at least one electron acceptor entity, and a fullerene composition.

In another embodiment, a layered composite for absorbing and utilizing radiant energy in a solar cell can comprise a push-pull copolymer including at least one electron donor entity and at least one electron acceptor entity configured in a first layer, and a fullerene composition configured in a second layer. The first layer can be configured to be in contact with the second layer.

Additional features and advantages of the invention will be apparent from the following detailed description which illustrates, by way of example, features of the invention.

### BRIEF DESCRIPTION OF THE DRAWINGS

FIG. 1 is a schematic three-dimensional representation of a fullerene composition in accordance with embodiments of the present invention;
FIG. 2 is a schematic representation of a solar cell that utilizes a blend of a fullerene composition and a push-pull copolymer in accordance with embodiments of the present invention; and
FIG. 3 is a schematic representation of a solar cell that utilizes separate layers of films, one of which includes a fullerene composition and the other of which includes a push-pull copolymer in accordance with embodiments of the present invention.

### DETAILED DESCRIPTION OF THE PREFERRED EMBODIMENT(S)

Before particular embodiments of the present invention are disclosed and described, it is to be understood that this invention is not limited to the particular process and materials disclosed herein as such may vary to some degree. It is also to be understood that the terminology used herein is used for the purpose of describing particular embodiments only and is not intended to be limiting, as the scope of the present invention will be defined only by the appended claims and equivalents thereof.

In describing and claiming the present invention, the following terminology will be used.

The singular forms "a," "an," and "the" include plural referents unless the context clearly dictates otherwise. Thus, for example, reference to "a polymer" includes reference to one or more of such materials.

The term "about" when referring to a numerical value or range is intended to encompass the values resulting from experimental error that can occur when taking measurements.

The term "push-pull copolymer" includes copolymers having an electron donor entity and an electron acceptor entity. Typically, these compositions are separated by a conjugated bridge. Charge asymmetry causes both moieties to act in tandem, favoring electronic motion in the direction of the electron donor entity to the electron acceptor entity. In one embodiment, a push-pull molecule or copolymer comprises donor and acceptor moieties spanned by a uniaxial charge transfer path, known as a conjugation path. Two different configurations can be realized by a shift in bonds from the electron donor entity to the electron acceptor entity. In the absence of solar illumination, the molecule resides in a ground state, which typically resembles a more aromatic configuration. Upon illumination, however, the ground state becomes an excited state, resulting in a net change in dipole moment.

The term "electron donor" can be used in at least two contexts. First, an electron donor can be an "electron donor entity" of a push-pull copolymer, which can contribute an electron to another entity within the copolymer or to other electron acceptors that are not part of the copolymer, but are blended or in contact therewith. Electron donors tend to keep a positive charge. Second, an electron donor can refer to a push-pull copolymer as a whole (which includes both an electron donor entity and an electron acceptor entity).

The term "electron acceptor" can also be used in at least two contexts. First, an electron acceptor can be "an electron acceptor entity " of a push-pull copolymer. This electron acceptor entity can absorb or attract an electron(s) from the electron donor entity. Second, an electron acceptor can refer to a fullerene composition that is blended or in contact with the push-pull copolymer, and which generally accepts or withdraws electrons from the push-pull copolymer as a whole.

The term "fluorene" refers to an aromatic compound, in which two benzene rings are connected via a homocyclic or hetercyclic five-member ring. Fluorene is an example of an electron acceptor entity of a push-pull copolymer.

The term "fullerene" is used to describe C₆₀ and other buckyballs generally, and derivatives thereof. Fullerene compositions as a whole are electron acceptors.

The terms "rotor" and "stator" refer to the molecular relationship between at least two moieties of a compound. For example, a compound can include rotor, which is a portion of a molecule that can rotate or otherwise change position with respect to the balance of the molecule. Typically, the rotor can be connected to at least one stator (or between two stators) such that rotation of the rotor is permitted with respect to the stator(s). Stators are typically relatively stationary moieties that can contribute to providing an axis for the rotor to rotate or change position.

The term "derivatized," "derivatives," "derivative group," etc., refers to lower alkyl and/or aryl substituents that are introduced onto the target molecules, such as fullerenes, fluorenes, etc. Lower alkyl includes straight-chained or branched C₁ to C₃₀. Aryl includes homocyclic and hetercyclic aromatic rings or fused aromatic rings. Combinations of aromatic rings, fused aromatic rings, and lower alkyl are also included. Other derivative groups include nitrogen-containing moieties, oxygen-containing moieties, sulfur-containing moieties, and phosphorus-containing moieties.

Ratios, concentrations, amounts, and other numerical data may be presented herein in a range format. It is to be understood that such range format is used merely for convenience and brevity and should be interpreted flexibly to include not only the numerical values explicitly recited as the limits of the range, but also to include all the individual numerical values or sub-ranges encompassed within that range as if each numerical value and subrange is explicitly recited. For example, a weight range of about 1 wt% to about 20 wt% should be interpreted to include not only the explicitly recited concentration limits of 1 wt% to about 20 wt%, but also to include individual concentrations such as 2 wt%, 3 wt%, 4 wt%, and sub-ranges such as 5 wt% to 15 wt%, 10 wt% to 20 wt%, etc.

With this in mind, a composition for use as an active absorbing material in a solar cell is provided. More specifically, a composition for absorbing and utilizing radiant energy in a solar cell can comprise a blend of a push-pull copolymer including at least one electron donor entity and at least one electron acceptor entity, and a fullerene composition. In another embodiment, a layered composite for absorbing and utilizing radiant energy in a solar cell can comprise a push-pull copolymer including at least one electron donor entity and at least one electron acceptor entity configured in a first layer, and a fullerene composition configured in a second layer. The first layer can be configured to be in contact with the second layer.

The push-pull copolymer can include a fluorene composition as the electron acceptor entity, including derivatized fluorene compositions. For example, the fluorene group can be derivatized by at least one moiety independently selected from the group consisting of lower aliphatic moieties, aryl moieties, nitrogen-containing moieties, oxygen-containing moieties, sulfur-containing moieties, and phosphorus-containing moieties. Further, there are certain functionalities that are likely to make a material an electron acceptor with respect to most other materials. Examples of such functionalities include CN, CF₃, F, C=O (keto groups), and diimides. These groups act as electron withdrawing groups, particularly if they are part of a conjugated system. With respect to the electron donor entity, this moiety can be selected from the group consisting of triarylamines, substituted triarylamines, carbazoles, substituted carbazoles, phenothiazines, substituted phenothiazines, benzothiadiazoles and substituted benzothiadiazoles, PPV (poly(para-phenylene vinylene)), PT (poly(thiophene), PPP (poly(para-phenylene)), and phthalocyanines, for example.

The fullerene composition can also be derivatized, such as by at least one moiety independently selected from the group consisting of lower aliphatic moieties, aryl moieties, nitrogen-containing moieties, oxygen-containing moieties, sulfur-containing moieties, and phosphorus-containing moieties.

Though not required, there are advantages to derivatizing the push-pull copolymer and/or the fullerene composition. These advantages include providing improved carrier mobility and solubility, and hence, better processability. Further, derivatizing these compositions can also contribute to modulation of solar energy absorption, providing a further mechanism for reducing (or otherwise modifying) band gaps.

When preparing a blend of the push-pull copolymer and the fullerene composition, the blend can be prepared at any functional ratio. This being stated, in one embodiment, the push-pull copolymer to fullerene composition molar ratio can be about 3:1 to 1:3. In another embodiment, the push-pull copolymer to fullerene composition molar ratio can be about 1:1. Regardless of the molar ratio of the blend components, the resultant composition should be formed in a configuration to be effective in absorbing and utilizing collected radiant energy, such as solar energy. Thus, in one embodiment, the blend can be configured as a thin film. An exemplary thickness of the thin film can be from about 50 nm to about 500 nm, though thicknesses outside of this range can also be used.

When preparing a layered composite of the push-pull copolymer and the fullerene composition, the composite can be prepared so that there is a relatively large surface area of interface between the two compositions. Each layer can be prepared at similar thickness as described with respect to the blend, e.g., from 50 nm to about 500 nm, though thicknesses outside of this range are within the scope of the present invention. Regardless of the thickness, surface area of contact/interface, etc, the resultant layered composite should be formed in a configuration to be effective in absorbing and utilizing collected radiant energy, such as solar energy.

A general scheme of a composition in accordance with embodiments of the present invention is provided as Formula 1 below:

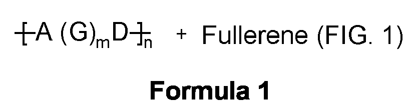

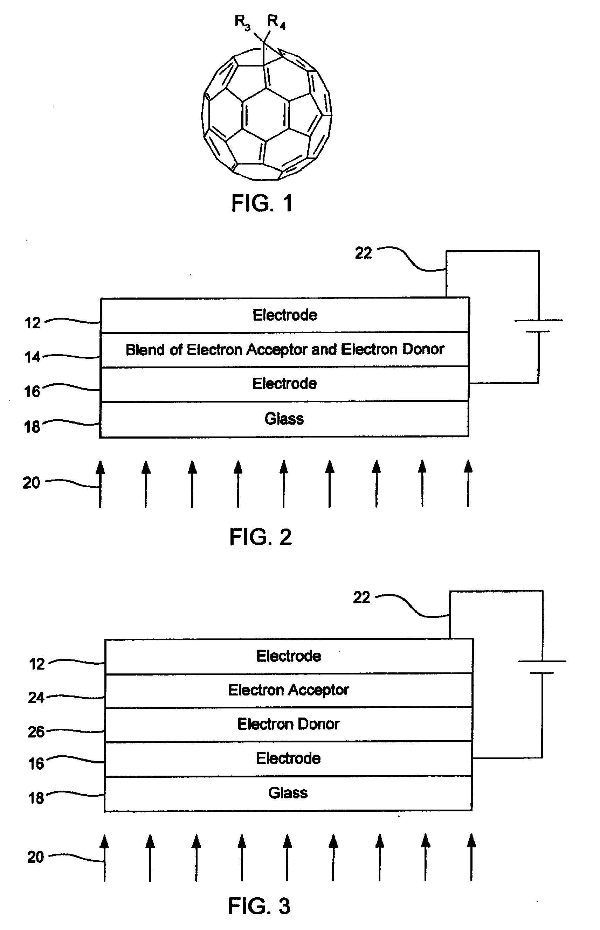

As shown in Formula 1 above, the symbol + indicates contact between the two compositions, e.g., blended or layered composite; m can be 0 or 1; n can be from 2 to 100; A can be an electron acceptor entity; D can be an electron donor entity; G can be a conjugated bridge; and R₃ and R₄ (See FIG. 1) can independently be H or a derivative group. With each of the embodiments described herein, though only two sites for functional group are shown on the fullerene composition in FIG. 1, it is important to note that others can be present as well. In further detail, R₃ and R₄ can independently be hydrogen, saturated or unsaturated lower aliphatic, substituted or unsubstituted aryl, or a functional group including nitrogen, oxygen, sulfur, and/or phosphorus. Group A can include, but is not limited to polyfluorenes, CN-PPV, CF₃-substited PPV, or perylene diimides. Group D can include, but is not limited to triarylamines, substituted triarylamines, carbazoles, substituted carbazoles, phenothiazines, substituted phenothiazines, benzothiadiazoles and substituted benzothiadiazoles, PPV (poly(para-phenylene vinylene)), PT (poly(thiophene), PPP (poly(para-phenylene)), and phthalocyanines. Group G is optional, and can include a conjugated connecting unit or bridge which links a rotor portion to a stator portion, i.e., A and D, and can include -CH=CH-containing groups, -CH=CR₅-containing groups, -CR₅=CR₆-containing groups, substituted acetylene, ethane or substituted ethane, -C=N-containing groups, -N=N-containing groups, etc, wherein R₅ and R₆ are substituents independently selected from the group consisting of branched or linear lower aliphatic, cyclic aliphatic, homocyclic or heterocyclic aryl (including single and fused ringed systems), and substituted derivatives thereof.

In further detail and in accordance with one particular embodiment, the present invention provides an active absorbing material for use in solar cells which includes a blend or layered composite of a polyfluorene push-pull electron donor copolymer and a fullerene electron acceptor compound. This composite is convenient for building high-performance solar cells with extended spectral absorption and high energy conversion efficiency, and is shown generally in Formula 2 below:

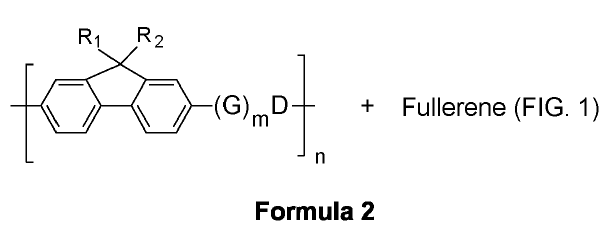

As shown in Formula 2 above, the symbol + indicates contact between the two compositions, e.g., blended or layered composite; m can be 0 or 1; n can be from 2 to 100; D can be an electron donor entity; G can be a conjugated bridge; and R₁ and R₂, as well as R₃ and R₄ (See FIG. 1) can independently be H or a derivative group. In further detail, R₁, R₂, R₃, and R₄ can independently be hydrogen, saturated or unsaturated lower aliphatic, substituted or unsubstituted aryl, or a functional group including nitrogen, oxygen, sulfur, and/or phosphorus. Group D can include, but is not limited to triarylamines, substituted triarylamines, carbazoles, substituted carbazoles, phenothiazines, substituted phenothiazines, benzothiadiazoles and substituted benzothiadiazoles, PPV (poly(paraphenylene vinylene)), PT (poly(thiophene), PPP (poly(para-phenylene)), and phthalocyanines. Group G is optional, and can include a conjugated connecting unit which links the rotor and stator portion together, i.e., A and D, and can include -CH=CH-containing groups, -CH=CR₅-containing groups, -CR₅=CR₆-containing groups, substituted acetylene, ethane or substituted ethane, -C=N-containing groups, -N=N-containing groups, etc., wherein R₅ and R₆ are substituents independently selected from the group consisting of branched or linear lower aliphatic, cyclic aliphatic, homocyclic or heterocyclic aryl (including single and fused ringed systems), and substituted derivatives thereof.

Formula 2 above provides a general formula depicting the general constituents present in the compositions of the present invention. As shown, this composition comprises a blend or layered composite of fluorene-electron donor group-containing copolymer and a fullerene compound, which can be a fullerene derivative. In the blend or composite shown, the fluorene copolymer acts as an electron donor as a whole (though the fluorene-portion of the copolymer itself is an electron acceptor entity), while fullerene compound acts as an electron acceptor. By introducing an electron donor group to the fluorene group to form fluorene/electron donor group-containing copolymer having a net electron donor capacity, the spectral absorption band gap inherently present with more typical fluorene systems can be reduced. Thus, a system can be prepared that has very wide absorption covering from substantially all to the entire visible spectrum. This can further be modulated by selection of appropriate derivative groups, as would be known by one skilled in the art after considering the present disclosure.

In still a more detailed embodiment, a conjugated push-pull copolymer can be used in accordance with embodiments of the present invention. Formula 3 depicts such a system, as follows:

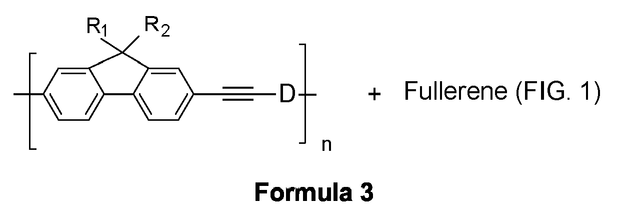

As shown in Formula 3 above, the symbol + indicates contact between the two compositions, e.g., blended or layered composite; n can be from 2 to 100; D can be an electron donor entity; and R₁ and R₂, as well as R₃ and R₄ (See FIG. 1) can independently be H or a derivative group. In further detail, R₁, R₂, R₃ and R₄ can independently be hydrogen, saturated or unsaturated lower aliphatic, substituted or unsubstituted aryl, or a functional group including nitrogen, oxygen, sulfur, and/or phosphorus. Group D can include, but is not limited to triarylamines, substituted triarylamines, carbazoles, substituted carbazoles, phenothiazines, substituted phenothiazines, benzothiadiazoles and substituted benzothiadiazoles, PPV (poly(para-phenylene vinylene)), PT (poly(thiophene), PPP (poly(para-phenylene)), and phthalocyanines.

In alternative related embodiments, two additional compositions in accordance with embodiments of the present invention are shown in Formulas 4 and 5, as follows:

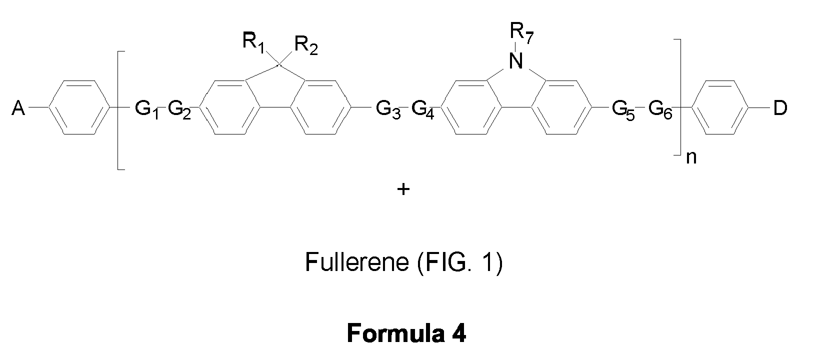

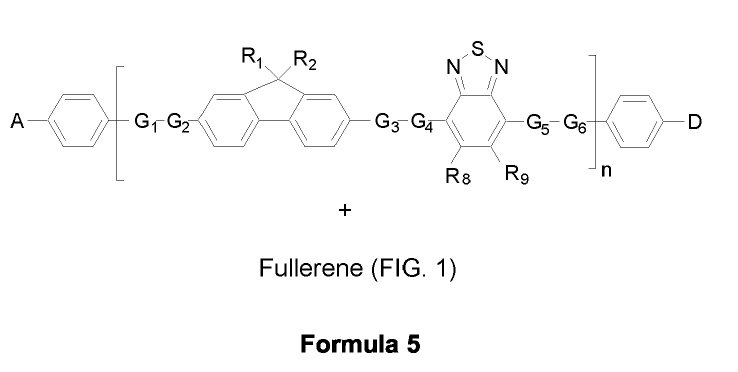

As shown in Formulas 4 and 5 above, n can be from 2 to 100; R₁, R₂, R₇, R₈, and R₉, as well as R₃ and R₄ (See FIG. 1) can independently be H or a derivative group; G₁-G₂, G₃-G₄, and G₅-G₆ can independently be conjugated connecting units that link rotor and stator portions together; A can be an electron acceptor group; and D can be an electron donor group.

In further detail with respect to Formulas 4 and 5 above, R₁, R₂, R₃, R₄, R₇, R₈, and R₉ can independently be hydrogen, saturated or unsaturated lower aliphatic, substituted or unsubstituted aryl, or a functional group including nitrogen, oxygen, sulfur, and/or phosphorus. Examples include, but are not limited to, -CH=CH-, -CH=CR₈-, -CR₈=CR₉ or substituted acetylene, ethane or substituted ethane, -C=N-, -N=N-, etc., wherein R₈ and R₉ are substituents independently selected from the group consisting of branched or linear lower aliphatic, cyclic aliphatic, homocyclic or heterocyclic aryl (including single and fused ringed systems), and substituted derivatives thereof. G₁-G₂, G₃-G₄, and G₅-G₆ can be conjugated connecting units which link rotor and stator portions together, and can also include -CH=CH-, -CH=CR₁₀-, -CR₁₀=CR₁₁ or substituted acetylene, ethane or substituted ethane, -C=N-, -N=N-, etc., wherein R₁₀ and R₁₁ are substituents independently selected from the group consisting of branched or linear lower aliphatic, cyclic aliphatic, homocyclic or heterocyclic aryl (including single and fused ringed systems), and substituted derivatives thereof. Further, A can represent electron withdrawing groups such as -C(=O)H, -C(=O)R₁₂, -C(=O)OR₁₂, - C(=O)OH, -CN, -N=O, -NO₂, CF₃, -SO₃H, -N=N-, -CH=NR₁₂, -CR₁₂=NR₁₃, =C=C(CN)₂, -C=C(COR₁₂)₂, -C=C(CO₂R₁₂)₂, -C=C(COR₁₂)(CO₂R₁₃), -SO₂OR₁₂, -S(=O)-R₁₂, -SO₂R₁₂, -PO₃H₂, -PO₃R₁₂R₁₃, wherein R₁₂ and R₁₃ are substituents independently selected from the group consisting of branched or linear lower aliphatic, cyclic aliphatic, homocyclic or heterocyclic aryl (including single and fused ringed systems), and substituted derivatives thereof. Additionally, D can represent an electron donating group, such as -O-, -OH, OR₁₄, -NH-, -NH₂, -NH₃, - NR₁₄R₁₅, -PR₁₄R₁₅, - PHR₁₄, -S-, -SH, -SR₁₄, -BH₂, -BHR₁₄, and -BR₁₄R₁₅, wherein R₁₄ and R₁₅ are substituents independently selected from the group consisting of branched or linear lower aliphatic, cyclic aliphatic, homocyclic or heterocyclic aryl (including single and fused ringed systems), and substituted derivatives thereof.

With the above-described solar cell materials in mind, these materials can be utilized in one of many know solar cell architectures known in the art. For example, a conventional solar cell configuration that can be used with the materials described herein include structures for carrying out the following steps: i) light absorption, i.e. absorption of photons; ii) exciton creation and diffusion, i.e., excitons are a mobile neutral combination of an electron in an excited state and a hole; iii) charge separation; iv) charge transport; and v) charge collection. Ideally, the excitons should reach a dissociation site, which may be on a first side of a semi-conductor, and the diffusion length should be at least equal to a predetermined thickness for sufficient or desired absorption. Charge separation typically occurs at the organic semi-conductor/metal interfaces or between materials with sufficiently different electron affinities and ionization potentials. In the latter case, one material can act as an electron acceptor while another material keeps the positive charge as an electron donor, as it actually donates the electron to the acceptor. Transport of charges is affected by recombination during a journey to the electrodes, particularly if the same material serves as transport medium for both electrons and holes. Next, in order to enter an electrode material with a relatively low work function, such as aluminum or calcium, the charges often have to overcome the potential barrier of a thin oxide layer. Both exciton and charge transport in organic materials usually require hopping from molecule to molecule. Thus close packing of materials leads to better transport properties. When designing donor acceptor materials for a solar cell, several factors should to be considered, including donor/acceptor properties, bandgap, and solubility. These factors have been considered in formulating the solar cell materials for use in accordance with embodiments of the present invention.

Turning more specifically now to FIGS. 2 and 3, in order to meet the requirement for efficient photon to charge conversion, several device architectures can be used. The following schematic architectures depict two exemplary devices which can be used for solar cells in accordance with embodiments of the present invention. Common elements in both solar cell architectures of FIG. 2 and FIG. 3 include a pair of electrodes 12, 16, a glass cover 18 which allows solar energy 20 to pass therethrough, and electrical circuitry 22 closing a circuit for electron flow. Specifically, in FIG. 2, an electron donor material, i.e. push-pull copolymer, is blended with an electron acceptor material, i.e. fullerene composition, shown generally at 14. In FIG. 3, the electron donor material, i.e. push-pull copolymer, 26 is present in a separate layer than the electron acceptor material, i.e. fullerene composition, 24. In either embodiment, charge separation occurs at an interface between these two materials. In one embodiment, the electrodes can be made of different materials, each having a different work function value. For example, the electron donor material can be in contact with the electrode material with the higher work function value, e.g., indium tin oxide, and the electron acceptor material can be in contact with the electrode with the lower work function value, e.g., aluminum. Other solar cell architectures can also be used, as would be known to one skilled in the art after considering the present disclosure.

### EXAMPLES

The following examples illustrate the embodiments of the invention that are presently best known. However, it is to be understood that the following are only exemplary or illustrative of the application of the principles of the present invention. Numerous modifications and alternative compositions, methods, and systems may be devised by those skilled in the art without departing from the spirit and scope of the present invention. The appended claims are intended to cover such modifications and arrangements. Thus, while the present invention has been described above with particularity, the following examples provide further detail in connection with what are presently deemed to be the most practical and preferred embodiments of the invention.

### Example 1 - Preparation of polymer solar cell active absorbing material

About 400 mg of a derivatized fullerene is admixed with about 100 mg of a derivatized fluorene-substituted benzothiadiazole copolymer in an excess of dichloromethane solvent. After thorough mixing, the solvent is removed by a drying process, leaving a thin film composition that includes both the derivatized fullerene and the derivatized fluorene-substituted benzothiadiazole copolymer. The fluorene-substituted benzothiadiazole copolymer in this embodiment functions as an electron donor; while fullerene derivative acts as an electron acceptor. The composition formed includes the materials shown in Formula 6, as follows: 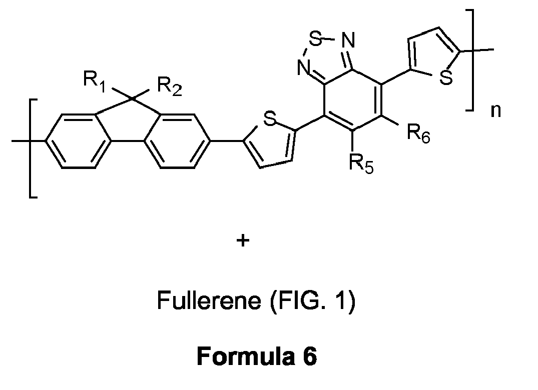 In Formula 6 above, n is 20, R₁ is methyl, R₂ is methyl, R₃ is methyloxycarbonyl (See FIG. 1), R₄ is methoxycarbonyl (See FIG. 1), R₅ is methyl, and R₆ is methyl. By introducing an electron donor group to the fluorene copolymer, and by selecting appropriate R groups, a reduction in band gap can be achieved such that a wider spectrum of solar energy is absorbable compared to the fluorene or the fullerene alone.

### Example 2 - Preparation of polymer solar cell active absorbing material

About 600 mg of a derivatized fullerene is admixed with about 200 mg of a derivatized fluorene-substituted phenothiazine copolymer in an excess of dichloromethane solvent. After thorough mixing, the solvent is dried, leaving a thin film composition that includes both the derivatized fullerene and the derivatized fluorene-substituted phenothiazine copolymer. The derivatized fluorene-substituted phenothiazine copolymer in this embodiment functions as an electron donor; while fullerene derivative acts as an electron acceptor. The composition formed includes the materials shown in Formula 7, as follows: 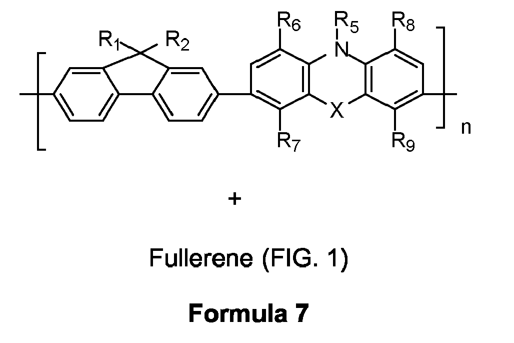 In Formula 2 above, n is 20, X is S, R₁ is methyl, R₂ is methyl, R₃ is methoxycarbonyl (See FIG. 1), R₄ is methyloxycarbonyl (See FIG. 1), R₅ is ethyl, R₆ is ethyl, R₇ is ethyl, R₈ is ethyl, and R₉ is ethyl. By introducing an electron donor group to the fluorene copolymer, and by selecting appropriate R groups, a reduction in band gap can be achieved such that a wider spectrum of solar energy is absorbable compared to the fluorene or the fullerene alone.

### Example 3 - Preparation of polymer solar cell active absorbing material

About 600 mg of a derivatized fullerene is admixed with about 200 mg of a derivatized fluorene-electron donor entity copolymer in an excess of dichloromethane solvent. After thorough mixing, the solvent is removed by a drying process, leaving a thin film composition that includes both the derivatized fullerene and the derivatized fluorene-substituted electron donor entity copolymer. The derivatized fluorene-electron donor entity copolymer in this embodiment functions as an electron donor; while fullerene derivative acts as an electron acceptor. The composition formed includes the materials shown in Formula 8, as follows: 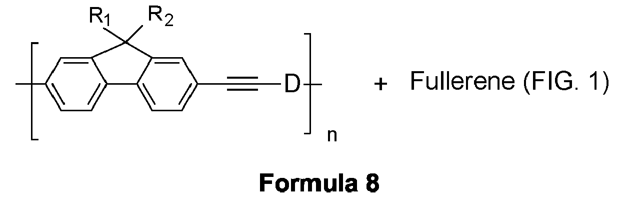 In Formula 8 above, n is 20, R₁ is methyl, R₂ is methyl, R₃ is methyloxycarbonyl (See FIG. 1), R₄ is methoxycarbonyl (See FIG. 1), and D is an electron donor entity. By introducing an electron donor group to the fluorene copolymer, and by selecting appropriate R groups, a reduction in band gap can be achieved such that a wider spectrum of solar energy is absorbable compared to the fluorene or the fullerene alone. In this embodiment, a conjugated bridge separates the derivatized fluorene composition from composition (D).

### Example 4 - Preparation of polymer solar cell active absorbing material

About 500 mg of a derivatized fullerene is admixed with about 150 mg of a derivatized fluorene-subsituted and carbazole substitited copolymer in an excess of dichloromethane solvent. After thorough mixing, the solvent is removed by a drying process, leaving a thin film composition that includes both the derivatized fullerene and the derivatized fluorene-substituted carbazole-substituted copolymer. The derivatized fluorene-substituted and carbazole-substituted copolymer in this embodiment functions as an electron donor; while fullerene derivative acts as an electron acceptor. The composition formed includes the materials shown in Formula 9, as follows: 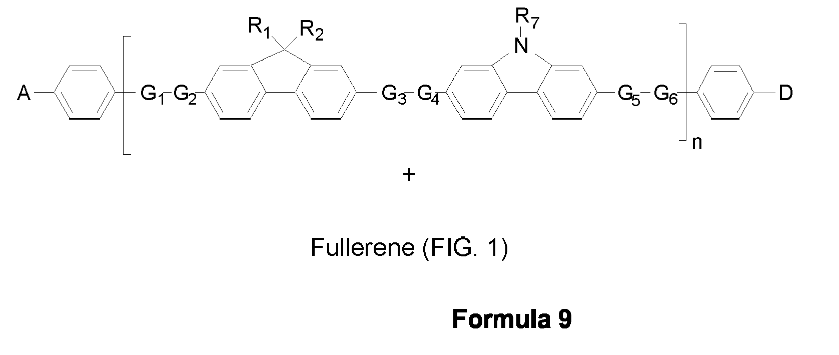 In Formula 9 above, n is 20, R₁ is methyl, R₂ is methyl, R₃ is methyloxycarbonyl (See FIG. 1), R₄ is methoxycarbonyl (See FIG. 1), R₇ is methyl, A is nitro, D is methoxy, G1-G2 is carbon-carbon triple bond, G3-G4 is carbon-carbon triple bond, and G5-G6 is also carbon-carbon triple bond. By introducing an electron donor group to the fluorene copolymer, and by selecting appropriate R groups, a reduction in band gap can be achieved such that a wider spectrum of solar energy is absorbable compared to the fluorene or the fullerene alone. In this embodiment, several conjugated bridges separate two different derivatized fluorene compositions from electron donors (D) and acceptors (A).

### Example 5 - Preparation of layered composite polymer solar cell active absorbing materials

About 100 mg of a derivatized fluorene-substituted benzothiadiazole copolymer was dissolved into an excess of dichloromethane solvent. After thorough mixing, the solvent is removed by a drying process, leaving a thin film composition that includes the derivatized fluorene-substituted benzothiadiazole copolymer. On top of this film was spin-coated another layer of about 400 mg of a derivatized fullerene film. The fluorene-substituted benzothiadiazole copolymer in this embodiment functions as an electron donor; while fullerene derivative acts as an electron acceptor. The compositions of each layer include the materials shown in Formula 10, as follows: 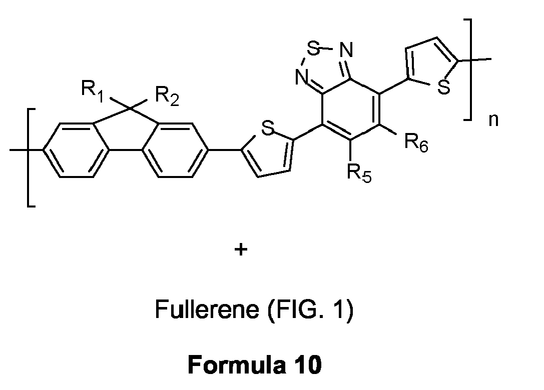 In Formula 6 above, n is 20, R₁ is methyl, R₂ is methyl, R₃ is methyloxycarbonyl (See FIG. 1), R₄ is methoxycarbonyl (See FIG. 1), R₅ is methyl, and R₆ is methyl. By introducing an electron donor group to the fluorene copolymer, and by selecting appropriate R groups, a reduction in band gap can be achieved such that a wider spectrum of solar energy is absorbable compared to the fluorene or the fullerene alone.

In each of Examples 1-5, though specific values are given for each derivative group, conjugated bridge, electron acceptor, electron donor, etc., it is to be noted many variations can be used in accordance with embodiments of the present invention, as described the specification, and as would be apparent to one skilled in the art after considering the present application. For example, n can be from 2 to 100. X (Example 2) can be O or S. A (Example 4) can represent electron withdrawing groups such as -C(=O)H, -C(=O)R₁₂, -C(=O)OR₁₂, -C(=O)OH, -CN, -N=O, -NO₂, CF₃, -SO₃H, -N=N-, -CH=NR₁₂, -CR₁₂=NR₁₃, =C=C(CN)₂, -C=C(COR₁₂)₂, -C=C(CO₂R₁₂)₂, -C=C(COR₁₂)(CO₂R₁₃), -SO₂OR₁₂, -S(=O)-R₁₂, -SO₂R₁₂, -PO₃H₂, -PO₃R₁₂R₁₃, wherein R₁₂ and R₁₃ are substituents independently selected from the group consisting of branched or linear lower aliphatic, cyclic aliphatic, homocyclic or heterocyclic aryl (including single and fused ringed systems), and substituted derivatives thereof. D (Examples 3) can be an electron donor group such as triarylamines, substituted triarylamines, carbazoles, substituted carbazoles, phenothiazines, substituted phenothiazines, benzothiadiazoles and substituted benzothiadiazoles, PPV (poly(para-phenylene vinylene)), PT (poly(thiophene), PPP (poly(para-phenylene)), and phthalocyanines. D (Example 4) can be an electron donor as well, such as -O-, -OH, OR₁₄, -NH-, -NH₂, -NH₃, - NR₁₄R₁₅, -PR₁₄R₁₅, -PHR₁₄, -S-, -SH, -SR₁₄, -BH₂, -BHR₁₄, and -BR₁₄R₁₅, wherein R₁₄ and R₁₅ are substituents independently selected from the group consisting of branched or linear lower aliphatic, cyclic aliphatic, homocyclic or heterocyclic aryl (including single and fused ringed systems), and substituted derivatives thereof. G₁-G₂, G₃-G₄, and G₅-G₆ (Example 4) can be conjugated connecting units which link a rotor and a stator together, and can also include - CH=CH-, -CH=CR₁₀-, -CR₁₀=CR₁₁ or substituted acetylene, ethane or substituted ethane, -C=N-, -N=N-, etc., wherein R₁₀ and R₁₁ are substituents independently selected from the group consisting of branched or linear lower aliphatic, cyclic aliphatic, homocyclic or heterocyclic aryl (including single and fused ringed systems), and substituted derivatives thereof. Further, each of the R groups can independently be H; saturated or unsaturated lower aliphatic or substituted lower aliphatic; substituted or unsubstituted aryl; or a functional group including nitrogen, oxygen, sulfur, and/or phosphorus.

While the invention has been described with reference to certain preferred embodiments, those skilled in the art will appreciate that various modifications, changes, omissions, and substitutions can be made without departing from the scope of the invention. It is therefore intended that the invention be limited only by the scope of the appended claims.

## Claims

1. A composition or layered composite for absorbing and utilizing radiant energy in a solar cell, comprising:
a push-pull copolymer including at least one electron donor entity and at least one electron acceptor entity, and
a fullerene composition.

2. A composition or layered composite as in claim 1, wherein the push-pull copolymer and the fullerene composition are blended together.

3. A composition or layered composite as in any of claims 1 and 2, wherein the push-pull copolymer is configured in a first layer, and the fullerene composition is configured in a second layer, said first layer being in contact with said second layer.

4. A composition or layered composite as in any of claims 1 through 3, wherein the electron accepting entity includes a fluorene group.

5. A composition or layered composite as in claim 4, wherein the fluorene group is derivatized by at least one moiety independently selected from the group consisting of lower aliphatic moieties, aryl moieties, nitrogen-containing moieties, oxygen-containing moieties, sulfur-containing moieties, and phosphorus-containing moieties.

6. A composition or layered composite as in any of claims 1 through 5, wherein the electron donor entity is selected from the group consisting of triarylamines, substituted triarylamines, carbazoles, substituted carbazoles, phenothiazines, substituted phenothiazines, benzothiadiazoles and substituted benzothiadiazoles, PPV (poly(para-phenylene vinylene)), PT (poly(thiophene), PPP (poly(para-phenylene)), and phthalocyanines.

7. A composition or layered composite as in any of claims 1 through 6, wherein the fullerene composition is derivatized by at least one moiety independently selected from the group consisting of lower aliphatic moieties, aryl moieties, nitrogen-containing moieties, oxygen-containing moieties, sulfur-containing moieties, and phosphorus-containing moieties.

8. A composition or layered composite as in any of claims 1 through 7, wherein the blend includes a push-pull copolymer to fullerene composition molar ratio of about 3:1 to 1:3.

9. A composition or layered composite as in any of claims 1 through 8, wherein the blend is in the form of a thin film.

10. A composition or layered composite as in claim 9, wherein the thin film is from 50 nm to 500 nm in thickness.

11. A composition or layered composite as in any of claims 1 through 10, wherein the push-pull copolymer includes a conjugated bridge between the electron acceptor entity and the electron donor entity.

12. A composition or layered composite as in claim 11, said composition in a rotor-stator configuration.

13. A composition or layered composite as in any of claims 1 through 12, wherein the push-pull copolymer is a net electron donor and the fullerene composition is an electron acceptor.

14. A solar cell comprising the composition or layer composite of any of claims 1 through 13.
